# EUROPEAN PATENT APPLICATION

(11) **EP 4 791 117 A1**
(43) Date of publication of application: **12.08.2026**
(21) Application number: 26156917.2
(22) Date of filing: 06.02.2026
(51) Int. Cl.: H05B 3/06, H05B 3/82, H05K 3/306

(54) **HEATER, ELECTRICAL CONNECTOR AND VEHICLE**

(30) Priority: 06.02.2025 CN 202510134174
(71) Applicant: Valeo Automotive Air Conditioning Hubei Co. Ltd, Jingzhou, Hubei 434007 (CN)
(72) Inventor: YAN, Chaochao, Shashi, 434007 (CN); XIAO, Ran, Shashi, 434007 (CN); ZHANG, Kong, Shashi, 434007 (CN); WANG, Jie, Shashi, 434007 (CN); GANESAN, Prakash, Shashi, 434007 (CN); DONG, Zhiguo, Shashi, 434007 (CN)
(74) Representative: Valeo Powertrain Systems

(57) **Abstract**

The present disclosure proposes a heater, comprising a housing, the housing being internally provided with: a circuit board, which has a first side and a second side that are opposite each other; a heating element, which is arranged on the first side of the circuit board and comprises a connecting end part at a terminal end; and an electrical connector, which is fixedly fitted and electrically connected to the circuit board on the second side of the circuit board. The connecting end part of the heating element extends through the circuit board to fixedly fit and electrically connect to the electrical connector.

The present disclosure further proposes an electrical connector, comprising a body and a spring cage arranged inside the body; the body can be fixed and electrically connected to the circuit board, and the electrical connector allows the connecting end part to extend through the circuit board and then insert into the spring cage, so that the connecting end part fixedly fits and electrically connects to the electrical connector.

The present disclosure proposes a vehicle, comprising a heater according to the present disclosure.

## Description

### Technical Field

The present disclosure relates to the field of machinery, and specifically relates to a heater, an electrical connector, and a vehicle comprising this heater.

### Background Art

Regarding an onboard heater, it is necessary to electrically connect a heating element for generating heat to a circuit board used for control. A pin of the heating element used for connection extends into the heating element by a certain length (typically greater than 30 mm) and connects to a resistance wire inside; if copper or another material that can be directly soldered to the circuit board is used, firstly the cost is higher, and secondly, since the heat transfer coefficient of copper is high, heat generated by the resistance wire during operation is quickly conducted to the solder joint on the circuit board; therefore, taking everything into account, a stainless steel material is selected for the heating core pin at present, but stainless steel cannot be directly soldered to a circuit board.

Therefore, in the prior art, an additional busbar is electrically connected to the circuit board, though the busbar itself must also be electrically connected to the circuit board by means of an electrical connector, and not only is the cost thereof higher, but also the volume occupied thereby is greater, and thus more regions on the circuit board are occupied thereby which affects the arrangement of electronic elements on the circuit board, which may necessitate enlarging the circuit board, and thus increases the total volume of the onboard heater, and mounting and fixing to the circuit board by means of a screw is necessary, thus further hampering assembly and wasting labour time.

Therefore, there is a need for a heater capable of solving the abovementioned problem.

### Summary of the Invention

An objective of the present disclosure is at least to solve the defects present in the prior art, the present disclosure proposing a heater, comprising a housing, the housing being internally provided with: a circuit board, which has a first side and a second side that are opposite each other; a heating element, which is arranged on the first side of the circuit board and comprises a connecting end part at a terminal end; and an electrical connector, which is fixedly fitted and electrically connected to the circuit board on the second side of the circuit board. The connecting end part of the heating element extends through the circuit board to fixedly fit and electrically connect to the electrical connector.

For example, according to some embodiments of the present disclosure, the electrical connector comprises a body and a spring cage arranged inside the body, the body being fixed and electrically connected to the circuit board, and the connecting end part being inserted into the spring cage.

The present disclosure further proposes an electrical connector, comprising a body and a spring cage arranged inside the body; the body can be fixed and electrically connected to the circuit board, and the electrical connector allows the connecting end part to extend through the circuit board and then insert into the spring cage, so that the connecting end part fixedly fits and electrically connects to the electrical connector.

For example, according to some embodiments of the present disclosure, the body has a cylindrical shape and is hollow inside, and the body is made of a conductive material and one end has an insertion hole for entering the interior of the body, the insertion hole being aligned with a through hole on the circuit board for the connecting end part to insert into the spring cage from the first side.

For example, according to some embodiments of the present disclosure, the spring cage has an annular shape, and an inner diameter of a middle section of the spring cage is less than an inner diameter of an end part section at two ends, the connecting end part extending into the spring cage and press-fitting with the middle section.

For example, according to some embodiments of the present disclosure, the body is coaxially arranged with the spring cage, such that the insertion hole is aligned with a central accommodating hole of the spring cage.

For example, according to some embodiments of the present disclosure, an end part section of the spring cage is provided with a protruding portion that radially protrudes outward from a main body portion of the end part section, used for forming a press-fit with an inner wall of the body.

For example, according to some embodiments of the present disclosure, the housing comprises a housing cover plate, and the housing cover plate is approximately parallel to the circuit board and located on the second side of the circuit board.

For example, according to some embodiments of the present disclosure, the electrical connector is provided with a cover part at one end thereof that is near the housing cover plate, and the cover part is made of an insulating material.

For example, according to some embodiments of the present disclosure, the cover part has a snap-fit part, and a circumferential surface of the body has a snap-fit groove that accommodates the snap-fit part.

For example, according to some embodiments of the present disclosure, the body is respectively provided with a first limiting part and a second limiting part at two ends of the spring cage, to axially fix the spring cage.

For example, according to some embodiments of the present disclosure, the first limiting part and/or the second limiting part is formed by turning over an edge of a portion of the body.

For example, according to some embodiments of the present disclosure, a smallest distance between the housing cover plate and the cover part is less than or equal to 5.6 mm.

For example, according to some embodiments of the present disclosure, a smallest distance between bodies of two adjacent electrical connectors is greater than or equal to 5.6 mm.

For example, according to some embodiments of the present disclosure, the electrical connector is soldered to the circuit board by means of wave soldering or reflow soldering.

For example, according to some embodiments of the present disclosure, the heater can be used at a voltage of 400 V or 800 V.

For example, according to some embodiments of the present disclosure, the electrical connector can be soldered to the circuit board by means of wave soldering or reflow soldering.

For example, according to some embodiments of the present disclosure, the electrical connector can be used at a voltage of 400 V or 800 V.

The present disclosure proposes a vehicle, comprising the heater of any one of the above embodiments.

### Brief Description of the Drawings

Fig. 1a shows a cutaway three-dimensional schematic drawing of a heater according to embodiments of the present disclosure.
Fig. 1b is a three-dimensional schematic drawing of the heater according to Fig. 1 after a housing and a housing cover plate have been hidden.
Fig. 2 shows a partially enlarged three-dimensional view of a portion shown in Fig. 1b.
Fig. 3 shows a sectional three-dimensional schematic drawing of a cooperating relationship between a heating connecting end part, a circuit board and an electrical connector.
Fig. 4 shows a three-dimensional view of an electrical connector according to an embodiment of the present disclosure.
Fig. 5 shows a cutaway three-dimensional schematic drawing of the electrical connector of Fig. 4.
Fig. 6 shows a three-dimensional schematic drawing of a spring cage of an electrical connector according to the present disclosure.
Figs. 7a - 7c show sectional views of different embodiments of a pin of an electrical connector connected to a circuit board according to the present disclosure.
Fig. 8a shows a schematic drawing of a first limiting part of an electrical connector according to the present disclosure.
Fig. 8b shows a schematic drawing of a second limiting part of an electrical connector according to the present disclosure.

### List of reference signs

1 heater, 11 housing, 12 housing cover plate
2 circuit board, 21 through hole
3 heating element, 31 connecting end part, 32 heating pipe, 33 flange
4 electrical connector, 41 body, 411 insertion hole, 412 snap-fit groove, 42 pin, 43 spring cage, 431 end part section, 432 middle section, 433 protruding portion, 44 cover part, 441 snap-fit part, 451 first limiting part, 452 second limiting part
5 fixing member
H1 smallest distance between housing cover plate and cover part
H2 smallest distance between bodies of two adjacent electrical connectors

### Detailed Description of the Invention

To make the objective, technical solutions and advantages of the present disclosure clearer, the technical solutions of embodiments of the present disclosure will be described clearly and completely below with reference to the drawings of specific embodiments of the present disclosure. Unless otherwise specified, the terms used herein have common meanings in the art. The same reference signs in the drawings refer to the same components.

Note that in the description of the present disclosure, unless otherwise expressly specified and defined, the terms "mount", "interconnect" and "connect" should be understood in a broad sense, which, for example, may be a fixed connection, a detachable connection or an integrated connection; a mechanical connection or an electrical connection; a direct connection, an indirect connection through an intermediate medium or a connection inside two elements. Those of ordinary skill in the art may understand the specific meanings of the abovementioned terms in the present disclosure according to the specific situation.

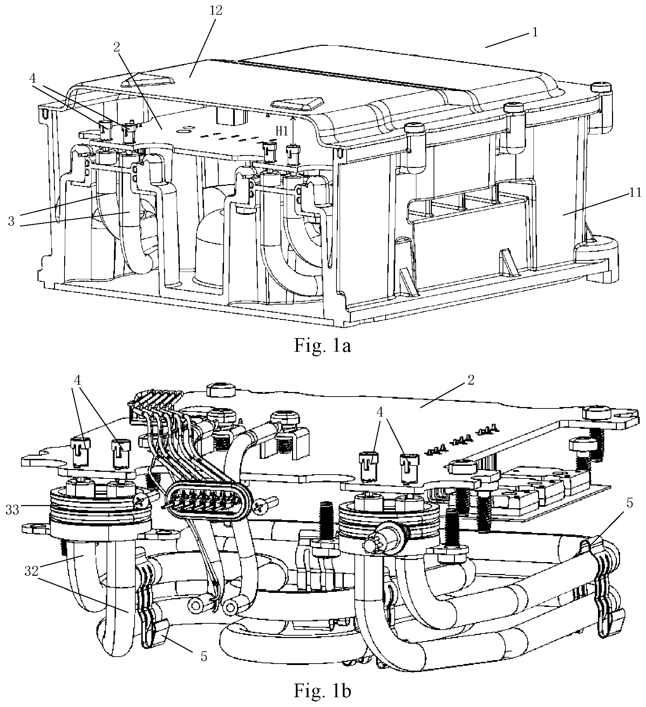

The present disclosure proposes an electrical connector 4 for a heater, and a heater 1 comprising this electrical connector 4. Fig. 1a shows a cutaway three-dimensional view of a heater 1 according to the present disclosure; as shown in Fig. 1, this heater 1 comprises a housing 11, and the housing 11 is internally provided with a circuit board 2, a heating element 3 and an electrical connector that electrically connects the heating element 3 to the circuit board 2. The housing 11 of the onboard heater is typically made of a metal material for example, to provide sufficient strength, to endure a possible gas explosion, and provides pressure resistance and corrosion resistance, and, since the heater is a high-voltage device, a metal housing can further provide grounding protection, for example, the metal housing 11 being connected to a vehicle ground wire by means of a grounding screw.

The circuit board 2 is provided with one or more electronic elements, used for realizing functions for the heater 1, such as signal transmission, power supply management, signal processing, control and logic and/or data storage and access.

The heating element 3 is used for generating heat according to control of the circuit board 2, to realize a heating function of the heater 1. The heating element 3 comprises a heating pipe 32 that generates heat and a connecting end part 31 for connecting to the circuit board. As shown in Fig. 1b, the heating pipe 32 is arranged in a meandering fashion in the housing 11, to increase the length of the heating pipe 32, increasing the heating power. To further increase the heating power, as shown in Fig. 1b, multiple heating pipes 32 may be provided; two ends of the heating pipe 32 may be configured as connecting end parts 31, the connecting end parts 31, for example, being columnar, such as a polygonal column, or preferably cylindrical. As shown in Fig. 1b, the heating pipe 32 is mounted and fixed to the interior of the housing 1 by one or more additional fixing members 5, to prevent detachment and displacement during use.

Two adjacent connecting end parts 31, for example, may be fixedly held by one round flange 33. As shown in Fig. 1b, to reduce the volume of the whole heater 1 and rationally arrange the overall space effectively, the whole heating element 3, for example, may be substantially overall mounted to one side of the circuit board 2, i.e. the heating pipe 32 meandering and winding at one side of the circuit board 2. The arrangement of the circuit board 2 specified herein is provided with the heating pipe 32 at one side which is a first side, and the other side opposite thereto is a second side.

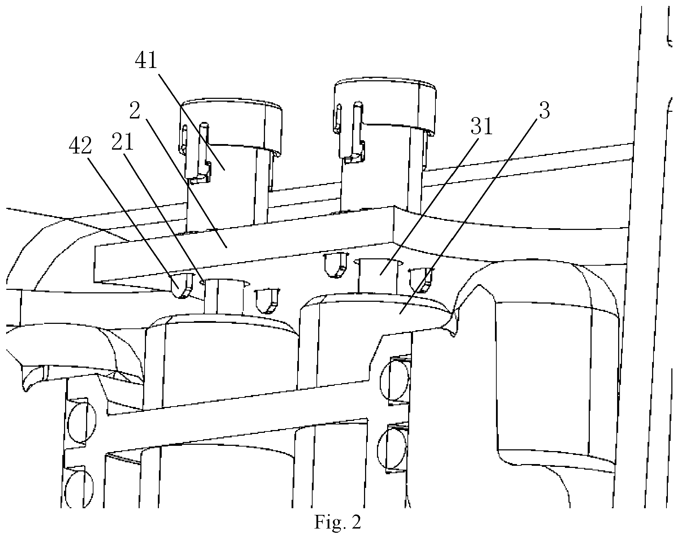

To electrically connect the heating element 3 to the circuit board 2, the present disclosure proposes an electrical connector 4, this electrical connector 4 being arranged on a second side of the circuit board 2, and fixedly fitting and electrically connecting to the circuit board 2. As shown in Fig. 2, this electrical connector 4 allows a connecting end part 31 to insert therein, and in particular allows the connecting end part 31 to extend through the circuit board 2 and insert into the electrical connector 4, to be fixedly fitted and electrically connected to the electrical connector.

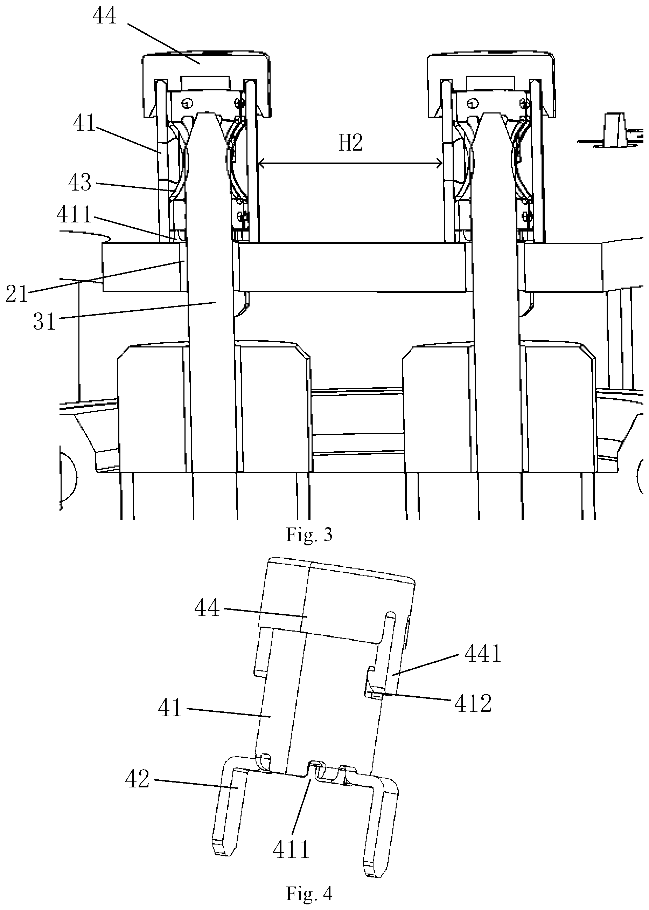

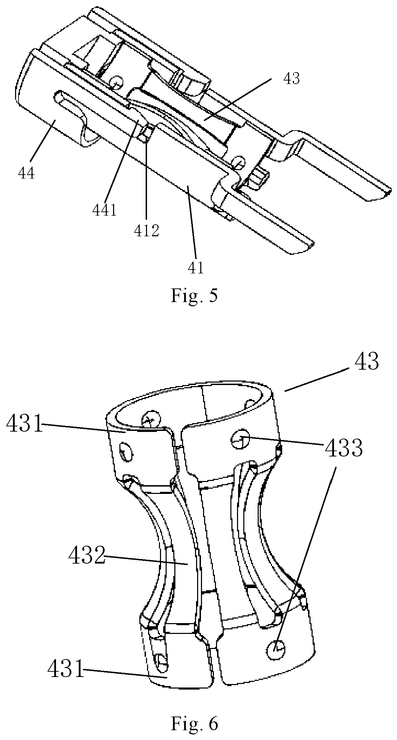

Figs. 4 and 6 show the structure of an electrical connector 4 according to an embodiment of the present disclosure. As shown in Fig. 4, an electrical connector according to the present disclosure may comprise a body 41, a spring cage 43 and a pin 42. The spring cage 43 may be arranged in the body 41, and the body 41 may be fixed and electrically connected to the circuit board 2 by means of the pin 42. In particular, the body 41, the spring cage 43 and the pin 42 are all made of a conductive material, so that the three conduct electricity. Thus, the connecting end part 31 may be electrically connected to the spring cage 43, and then electrically connected to the circuit board 2 via the body 41 and the pin 42.

As shown in Fig. 4, the body 41 may have a cylindrical shape and be hollow inside, to accommodate the spring cage 43. The body 41 may have an insertion hole 411 at one end for entering the interior of the body 41, and correspondingly, a corresponding through hole 21 may be provided on the circuit board 2, this insertion hole 411 being aligned with the through hole 21 on the circuit board 2, to form a passage for receiving or retrieving the spring cage 43 inside the body 41. Consequently, the connecting end part 31 may extend through the circuit board 2 from the first side to insert into the spring cage 43 via the insertion hole 411, so as to be reliably electrically connected and fixed.

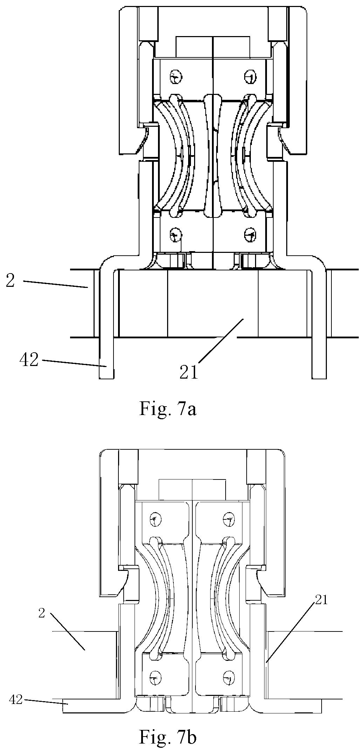

The spring cage 43 may allow the connecting end part 31 to insert therein via the insertion hole 411, and, in particular, forms a press-fit with the connecting end part 31, so as to achieve a reliable electrical connection and fixed connection. Specifically, the spring cage 43 may have an annular shape, and hence the spring cage 43 has a centrally located accommodating hole for the connecting end part 31 to be inserted. In particular, the body 41 may be coaxially arranged with the spring cage 43, such that the insertion hole 411 is aligned with a central accommodating hole of the spring cage 43, as shown in Figs. 3 and 7a, so that, when the electrical connector 4 is correctly positioned, the connecting end part 31 may directly insert into the spring cage 43.

Furthermore, as shown in Fig. 6, the spring cage 43 has an end part section 431 located at two ends and a middle section 432 located between the two end part sections 431; an inner diameter of the middle section 432 may be smaller than an inner diameter of the end part section 431 at the two ends, forming an accommodating hole that narrows inward from both ends toward the central aperture. In particular, when the spring cage 43 is in a non-deformed state (without the connecting end part 31 inserted), a smallest inner diameter of the middle section 432 is smaller than a largest outer diameter of the connecting end part 31, so that the connecting end part 31 directly forms a press-fit (interference fit) with the middle section 432, thus ensuring a reliable electrical connection and fixed fitting between the heating element 3 and the spring cage 43.

For example, as shown in Fig. 6, the middle section 432 of the spring cage 43 may have multiple slits extending in an axial direction of the spring cage 43, to reserve more space for the middle section 432 to deform, beneficial for a press-fit between the connecting end part 31 and the middle section 432.

As shown in Figs. 3 and 5, this spring cage 43 may be tightly joined to an inner wall of the body 41, to ensure a reliable electrical connection between the spring cage 43 and the body 41; in particular, a largest outer diameter of the spring cage 42 is greater than a smallest inner diameter of the body 41. For example, as shown in Fig. 6, a protruding portion 433 that partially protrudes radially outward may be provided at a joint of the spring cage 43 and the body 41, and for example, the protruding portion 433 is arranged on an end part section 431 and protrudes radially outward from a main body portion of the end part section 431, to further ensure a press-fit with the inner wall of the body 41.

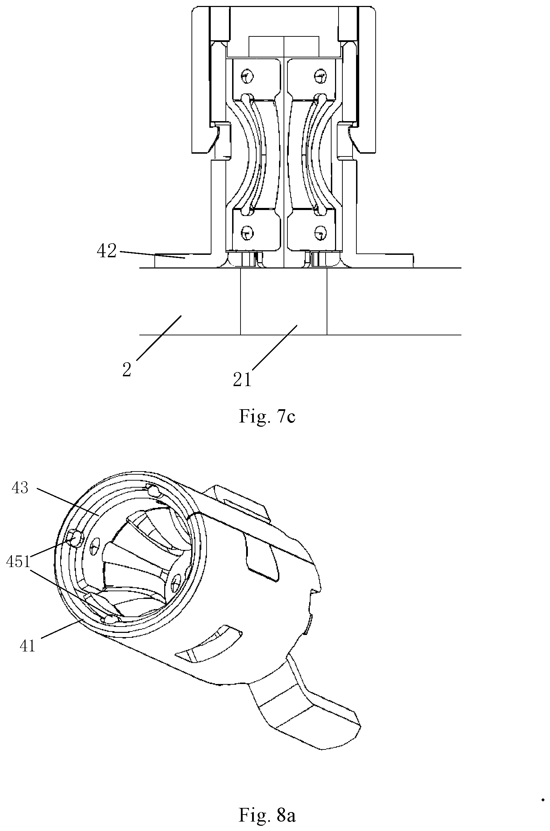

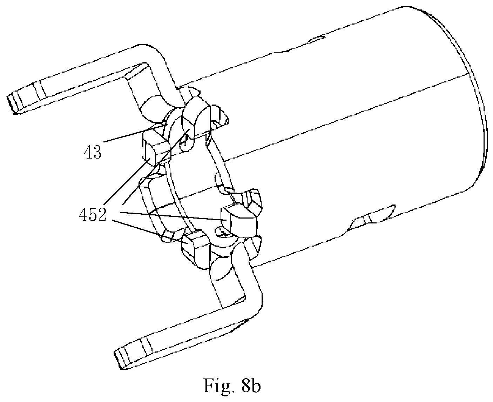

As shown in Figs. 8a and 8b, to fix the spring cage 43 in the axial direction, so as to allow the connecting end part 31 to be stably and reliably electrically connected, the body 41 of the present disclosure may further have a first limiting part 451 and a second limiting part 452 that have a limiting role. The first limiting part 451 and the second limiting part 452 are respectively arranged at two ends of the spring cage 43, to restrict movement of the spring cage 43 in both directions along the axis. For example, as shown in Fig. 8a and Fig. 8c, multiple first limiting parts 451 and second limiting parts 452 may be respectively provided, such as 4 as shown. Furthermore, multiple first limiting parts 451 and second limiting parts 452 may further be aligned one-to-one in the axial direction, which distributes stress evenly.

Furthermore, the first limiting part 451 and/or second limiting part 452 may be formed by turning over an edge; for example, as shown in Fig. 8b, the second limiting part 452 is formed by turning over an edge of a portion of the body 41. Thus, before the second limiting part 452 has been formed (the corresponding portion of the body 41 has not been folded over at the edge), the spring cage 43 can be inserted into the body 41 from one end where the second limiting part 452 is located, and after the spring cage 43 abuts the first limiting part 451 and is in position, the edge turning process is performed, ensuring that the spring cage 43 is unable to move in the axial direction.

Furthermore, the heater according to the present disclosure may be an onboard heater; since existing common onboard heaters normally have a voltage of 400 V or 800 V, a voltage of 400 V or 800 V is likewise suitable for the heater 1 according to the present disclosure. However, correspondingly, regarding the two different voltages of 400 V and 800 V for the heater 1, the choice of electronic elements and copper layout on a circuit board, and parts such as a heating element (resistance value and dielectric strength) are different; these components may not be commonly usable at the two different voltages, and therefore must be selected and designed according to specific voltage requirements to respectively satisfy electrical safety and performance at the two voltages. For high-voltage products with insulation requirements that must be met, for example, an 800 V product typically may be required to withstand a voltage of 2800 VAC (requirements may be different for different clients, different products and different models), with an air gap requirement ≥ 5.6 mm, wherein an air gap minimum requirement is 4.6 mm, and dimensional and assembly tolerance margins must be 1 mm to ensure safety. Therefore, a smallest distance H2 between bodies 41 of two adjacent electrical connectors 4 (for example, corresponding to two connecting end parts 31 on the same flange 33) is greater than or equal to 5.6 mm, as shown in Fig. 3. A problem of creepage distance may be solved by adding a slot in the circuit board, and therefore is not elaborated on here.

To satisfy the air gap requirement, in a scenario in which a distance between two adjacent connecting end parts 31 is determined (for example, the specification for the heating element is already used and mass produced, hence difficult to alter), it is necessary to cause the outer diameter of the electrical connector 4 to be as small as possible. For example, the electrical connector 4 coaxially fits to the connecting end part 31; an outer diameter of the electrical connector 4 should be less than a centre spacing between the connecting end parts 31 (such as 12 mm), and a minimum air gap requirement (such as 5.6 mm), for example, is less than 6.4 mm.

Furthermore, the housing 11 of the heater 1 according to the present disclosure is sealed by means of a housing cover plate 12; as shown in Fig. 1a, this housing cover plate 12 is arranged on the second side of the circuit board 2, and the housing cover plate 12 is approximately parallel to the circuit board 2. Since the second side is not provided with the heating pipe 32, provided that electronic elements (such as the electrical connector 4) on the circuit board are accommodated, a distance between the housing cover plate 12 and the circuit board 2 may be as small as possible to save on space. This housing cover plate 12, for example, is also made of a metal material, such as aluminium, for electrically connecting to the housing 11, equivalent to forming a ground. Moreover, the metal housing cover plate 12 and the metal housing 11 seal the circuit board therein, which can improve the electromagnetic compatibility (EMC) of the product. Thus, electrical safety between the housing cover plate 12 and the electrical connector 4 must likewise be ensured. To ensure the requirement is met that the air gap ≥ 5.6 mm, in normal situations, the gap between the body 41 and the cover plate 12 must be at least 5.6 mm. However, this clearly maximally increases the volume of the heater 1.

Hence, a cover part 44 may be provided on the electrical connector 4 according to the present disclosure; this cover part 44 is arranged at one end of the body 41 near the housing cover plate 12, i.e. at the opposite end to the insertion hole 411. This cover part 44 may be made of an insulating material; thus the distance between the electrical connector 4 and the housing cover plate 12 can be greatly reduced, while satisfying safety requirements. Thus, as shown in Fig. 1a, a smallest distance H1 between the cover part 44, which is the part of the electrical connector 4 closest to the housing cover plate 12, and the housing cover plate 12 may be less than or equal to 5.6 mm, thus greatly reducing the volume of the heater 1.

This cover part 44 may have a snap-fit part 441, and a circumferential surface of the body 41 has a snap-fit groove 412 that accommodates the snap-fit part 441, as shown in Figs. 4 and 5, to fix the cover part 44 relative to the body 41. For example, multiple snap-fit parts 441 may be provided, such as two as shown in Fig. 4, and multiple snap-fit parts 441 may be evenly spaced apart from each other.

Furthermore, the electrical connector further comprises a pin 42, and the pin 42 is electrically connected to a body, and is integrally formed with the body for example. The pin 42, for example, is electrically connected to one end of the body 41 that is provided with the insertion hole 411, and a terminal end of the pin 42 extends away from the body 41, and the number of pins 42 provided may be two for example, as shown in Figs. 4 and 5. Due to having the pin 42, the electrical connector 4 may be soldered to the circuit board 2 by means of wave soldering or reflow soldering, and the specific connection means may be as shown in any one of Figs. 7a - 7c.

As shown in Fig. 7a, a terminal end of the pin 42 extends in an axial direction of the body 41, and the pin 42 extends through a corresponding pin hole on the circuit board 2, and then is soldered and fixed by means of wave soldering. As shown in Figs. 7b and 7c, the terminal end of the pin 42 extends perpendicular to the axial direction of the body 41; in Fig. 7b, the whole body 41 extends into the through hole 21, and the pin 42 may be soldered and fixed to a surface of the first side of the circuit board 2 by means of reflow soldering; in Fig. 7c, the whole electrical connector 4 is located on the second side of the circuit board 2, and the pin 42 may be soldered and fixed to a surface of the second side of the circuit board 2 by means of reflow soldering.

The present disclosure further proposes a vehicle; the vehicle may be a saloon, a special-purpose vehicle, a coach, a goods vehicle, an off-road vehicle, a tipper lorry, a tractor unit, etc., and the vehicle according to the present disclosure comprises the heater according to the present disclosure.

It should be understood that the above description has an explanatory rather than restrictive purpose. For example, the above embodiments (and/or aspects thereof) may be used in combination with each other. In addition, without departing from the scope of the present disclosure, multiple amendments may be performed to adapt specific situations or materials to the teachings of the present disclosure. The functions and performance of various elements or modules described herein are only provided for explanation and are by no means restrictive, being rather only exemplary embodiments. After reading the above description, many other embodiments and amendments within the spirit and scope of the claims would be obvious to a person skilled in the art. Therefore, the scope of the present disclosure should be determined with reference to the whole scope of the attached claims and equivalents as granted by the claims.

In the attached claims, the terms "comprise" and "wherein" are used as simple English equivalents of the corresponding terms "include" and "in which". In addition, in the following claims, the terms "first", "second" and "third", etc. only act as labels, and do not count as applying a numerical value requirement on the target thereof.

## Claims

1. Heater (1), comprising a housing (11), the housing (11) being internally provided with:
a circuit board (2), which has a first side and a second side that are opposite each other,
a heating element (3), which is arranged on the first side of the circuit board (2) and comprises a connecting end part (31) at a terminal end,
and an electrical connector (4), which is fixedly fitted and electrically connected to the circuit board (2) on the second side of the circuit board (2),
wherein the connecting end part (31) of the heating element (3) extends through the circuit board (2) to fixedly fit and electrically connect to the electrical connector (4).

2. Heater (1) according to Claim 1,
wherein the electrical connector (4) comprises a body (41) and a spring cage (43) arranged inside the body (41), the body (41) being fixed and electrically connected to the circuit board (2), and the connecting end part (31) being inserted into the spring cage (43).

3. Heater (1) according to Claim 2, wherein
the body (41) has a cylindrical shape and is hollow inside, and the body (41) is made of a conductive material and one end has an insertion hole (411) for entering the interior of the body (41), the insertion hole (411) being aligned with a through hole (21) on the circuit board (2) for the connecting end part (31) to insert into the spring cage (43) from the first side.

4. Heater (1) according to claim 2 or 3 , wherein
the spring cage (43) has an annular shape, and an inner diameter of a middle section (432) of the spring cage (43) is less than an inner diameter of an end part section (431) at two ends, the connecting end part (31) extending into the spring cage (43) and press-fitting with the middle section (432).

5. Heater (1) according to any of Claims 2-4, wherein
the body (41) is coaxially arranged with the spring cage (43), such that the insertion hole (411) is aligned with a central accommodating hole of the spring cage (43).

6. Heater (1) according to Claim 5, wherein
an end part section (431) of the spring cage (43) is provided with a protruding portion (433) that radially protrudes outward from a main body portion of the end part section, used for forming a press-fit with an inner wall of the body (41).

7. Heater (1) according to any of Claims 2 to 6, wherein
the housing (11) comprises a housing cover plate (12) made of a metal material, and the housing cover plate (12) is approximately parallel to the circuit board (2) and located on the second side of the circuit board (2).

8. Heater (1) according to Claim 7, wherein
the electrical connector (4) is provided with a cover part (44) at one end thereof that is near the housing cover plate (12), and the cover part (44) is made of an insulating material.

9. Heater (1) according to Claim 8, wherein
the cover part (44) has a snap-fit part (441), and a circumferential surface of the body (41) has a snap-fit groove (412) that accommodates the snap-fit part (441).

10. Electrical connector (4), comprising a body (41) and a spring cage (43) arranged inside the body (41),
wherein the body (41) can be fixed and electrically connected to a circuit board (2), and the electrical connector (4) allows the connecting end part (31) to extend through the circuit board (2) and then insert into the spring cage, so that the connecting end part (31) fixedly fits and electrically connects to the electrical connector (4).

11. Electrical connector (4) according to Claim 10, wherein
the body (41) has a cylindrical shape and is hollow inside, and the body (41) is made of a conductive material and one end has an insertion hole (411) for entering the interior of the body (41), the insertion hole allowing the connecting end part (31) to insert into the spring cage (43).

12. Electrical connector (4) according to Claim 10 or 11, wherein
the spring cage (43) has an annular shape, and an inner diameter of a middle section (432) of the spring cage (43) is less than an inner diameter of an end part section (431) at two ends, the connecting end part (31) extending into the spring cage (43) and press-fitting with the middle section (432).

13. Electrical connector (4) according to Claim 12, wherein
the body (41) is coaxially arranged with the spring cage (43), such that the insertion hole (411) is aligned with a central accommodating hole of one end part section (431) of the spring cage (43).

14. Electrical connector (4) according to Claim 13, wherein
an end part section (431) of the spring cage (43) is provided with a protruding portion (433) that radially protrudes outward from a main body portion of the end part section, used for forming a press-fit with an inner wall of the body (41).

15. Electrical connector (4) according to any one of Claims 15 - 18, wherein the electrical connector (4) is provided with a cover part (44) at one end thereof that is opposite the insertion hole (411), and the cover part (44) is made of an insulating material.
